Europäisches Patentamt

European Patent Office

Office européen des brevets

(11) Veröffentlichungsnummer: **0 501 165 A1**

## EUROPÄISCHE PATENTANMELDUNG

(21) Anmeldenummer: **92101584.8**

(22) Anmeldetag: **31.01.92**

(51) Int. Cl.5: **H01M 10/48**, G01R 31/36

(30) Priorität: **21.02.91 DE 4105369**

(43) Veröffentlichungstag der Anmeldung:
**02.09.92 Patentblatt 92/36**

(84) Benannte Vertragsstaaten:
**ES FR GB IT NL**

(71) Anmelder: **LOEWE OPTA GMBH**
**Industriestrasse 11 Postfach 220**
**W-8640 Kronach(DE)**

(72) Erfinder: **Schaas, Gerhard, Ing. grad.**
**Sonnenleite 11**
**W-8633 Rödental(DE)**

(54) **Ladezustandsanzeige einer Batterie oder eines Akkumulators in einem Fernbedienungsgeber.**

(57) Eine Ladezustandsanzeige einer Batterie oder eines Akkumulators in einem Fernbedienungsgeber für nachrichtentechnische Geräte, insbesondere Geräte der Unterhaltungselektronik, z.B. Rundfunk-, Fernsehgeräte oder Videorecorder, welcher Fernbedienungsgeber mittels Tasten, Analogwertstellern oder Sprache eingegebene Befehle in einer Befehlsaufbereitungsschaltung aufbereitet und in einer Sendeschaltung mit einem Träger moduliert oder unmoduliert an das zu steuernde Gerät mit einem Übertragungsmedium, wie Infrarotlicht, Ultraschall oder elektromagnetische Wellen, überträgt, mit einer Überwachungseinrichtung für die Überwachung des Ladezustandes und/oder der entsprechenden Spannung der Batterie oder des Akkumulators, welches Gerät eine Empfängerschaltung aufweist und die Befehle demoduliert, aufbereitet oder direkt zur Funktionssteuerung an die zu steuernden Funktionselemente in dem Gerät leitet, zeichnet sich darin aus, daß die Überwachungseinrichtung in Abhängigkeit von dem Ladezustand der Batterie oder des Akkumulators ein adäquates Informationsmaterial generiert, das von dem Fernbedienungsgeber an das zu steuernde Gerät übertragen wird, das einen Fernbedienungsempfänger und eine Auswerteschaltung für das Informationssignal und ein Anzeigeelement mit einer Ansteuerschaltung zur Anzeige des Ladezustandes enthält.

EP 0 501 165 A1

Die Erfindung betrifft eine Ladezustandsanzeige einer Batterie oder eines Akkumulators in einem Fernbedienungsgeber für nachrichtentechnische Geräte, insbesondere Geräte der Unterhaltungselektronik, z.B. Rundfunk-, Fernseh-, Videogeräte, Tonbandgeräte oder CD- und Plattenspieler, mit den im Oberbegriff des Anspruchs 1 angegebenen Merkmalen.

Es sind Schaltungen bekannt, die eine Batterie in einem Fernbedienungsgeber überwachen und durch ein Leuchtsignal anzeigen, daß eine bestimmte Mindestspannung der Batterie vorhanden ist, um dem Benutzer einen Hinweis zu geben, daß er die Batterie austauschen bzw. den Akkumulator wieder aufladen muß, sobald diese Anzeige erlischt. Eine derartige Anordnung ist beispielsweise in der DE-OS 26 38 958 beschrieben. Die bekannte Anordnung weist den Nachteil auf, daß die Anzeige eine ständige Belastung für die Batterie darstellt. Außerdem gewährleistet die in der bekannten Schaltung verwendete Referenzdiode wegen des ihr eigenen Kennlinienverlaufs keinen abrupten Übergang der Anzeige. Bei anderen Fernbedienungsgebern, insbesondere solchen, die mit Funkwellen arbeiten und zur Steuerung von Garagentoröffnern dienen, ist vorgesehen, daß eine Diode aufleuchtet, sobald der Bedienknopf des Fernbedienungsgebers bedient wird. Leuchtet die Leuchtdiode bei der Bedienung nicht mehr auf, so ist dies eine Indikation dafür, daß die Batterie unter einen Schwellenwert abgesunken ist und der Betrieb nicht mehr sichergestellt ist. Derartige Betriebsanzeigen sind ferner aus allgemein einsetzbaren Fernbedienungsgebern, die als Übertragungsmedium Infrarotlicht verwenden, bekannt, beispielsweise aus dem Siemens-Datenbuch 1979/1980 "Infrarot-Fernbedienung Baugruppensystem INFRAFERN", Seite 30 ff.

Aber auch die weiteren vorher angegebenen Anzeigeeinrichtungen weisen den im Hinblick auf die DE-OS 26 38 958 angegebenen Nachteil auf, daß neben der Ladezustandsausweteschaltung auch die Anzeigeelemente während der Bedienung in Betrieb sind, so daß ein erhöhter Stromverbrauch gegeben ist.

Eine Ladezustandsanzeige der beschriebenen Art ist weiterhin aus der DE 28 47 052 B2 bekannt, bei der die Betriebsanzeigediode bei Betätigung der Fernbedienung sofort verlöscht, sobald der Strom für eine genügende Mindestreichweite nicht mehr ausreicht, so daß dem Benutzer der Fernbedienung ein eindeutiger Hinweis darauf gegeben wird, daß der Grund des Versagens bei einer zu schwachen Batterie liegt, die er selbst auswechseln kann. Aber auch diese Ladezustandserkennungsanzeige setzt voraus, daß zur Anzeige des Ladezustandes fortlaufend ein Strom gezogen wird, der zumindest während der Betätigungszeit einer Bedienungstaste des Fernbedienungsgebers durch die Leuchtdiode fließt.

Es hat sich gezeigt, daß die Leuchtdiode als Betriebsanzeige oder Ladezustandsanzeige in einem Fernbedienungsgeber so dimensioniert und plaziert sein muß, daß das von ihr abgestrahlte Licht augenfällig ist. Dies bedingt einen noch höheren Stromverbrauch während der Anzeige. Bei den meisten Fernbedienungsgebern ist oftmals eine Plazierung der Leuchtdiode in dem Gehäuse an einer Stelle, die für den Benutzer stets sichtbar ist, nicht möglich. Weiterhin schenkt der Bedienende einer solchen Anzeige keine Aufmerksamkeit, insbesondere dann nicht, wenn während der Bedienung auf dem Bildschirm eines Fernsehgerätes oder dem Anzeigedisplay eines programmierbaren Videorecorders Einstellfunktionen verfolgt werden müssen.

Ausgehend vom bekannten Stand der Technik liegt der Erfindung die Aufgabe zugrunde, unter Vermeidung der aufgezeigten Nachteile eine Ladezustandsanzeige eingangs genannter Art derart auszubilden, daß der Ladezustand der Batterie sichtbar in Erscheinung tritt, zumindest dann ein weithin sichtbares Signal abgegeben wird, wenn der Ladezustand eine Mindestschwelle unterschritten hat, die eine einwandfreie Funktion der Fernbedienungsgeberschaltung nicht mehr gewährleistet bzw. die Bedienung des Gerätes aus normaler Entfernung nicht mehr ermöglicht.

Die Aufgabe wird erfindungsgemäß durch die im Kennzeichen des Anspruchs 1 angegebene technische Lehre gelöst, wonach von der Überwachungseinrichtung in dem Fernbedienungsgeber in Abhängigkeit von dem Ladezustand der Batterie odes des Akkumulators ein adäquates Informationssignal generiert wird. Dieses Informationssignal wird von dem Sender des Fernbedienungsgebers an einen Fernbedienungsempfänger in dem zu steuernden Gerät übertragen, von diesem demoduliert und ausgewertet und einer Ansteuerschaltung für ein Anzeigeelement zugeführt, mit dem der Ladezustand angezeigt wird. Der Vorteil liegt darin, daß nur eine ganz kurze Abfrage des Ladezustandes der Batterie oder des Akkumulators erforderlich ist, also eine Kurzzeitmessung erfolgt, die auch bei Betätigung der Tasten einer Tastatur oder bei Eingabe eines Sprachbefehls nur einmal zu erfolgen braucht oder aber nur bei Betätigung einer Ein/Aus-Taste am Fernbedienungsgeber während des Einschaltens oder vor dem Ausschalten erfolgt. In allen diesen Betriebsfällen wird jeweils ein Informationssignal generiert, das in der Empfängerschaltung in ein Anzeigesignal umgesetzt wird oder eine Anzeigeschaltung eines Anzeigeelementes steuert, um weithin sichtbar oder hörbar aufgenommen werden zu können. Die Ladezustandsanzeige kann dabei so aufgebaut sein, daß der Benutzer eine Information über den tatsächlichen Ladezustand erhält. Es ist aber auch möglich, wie im Anspruch 2 angegeben, nur einen bestimmten Zustand anzuzeigen, z.B. einen Warnzustand, daß die Ladung der Batterie oder des Akkumulators so weit abgesunken ist, daß eine einwandfreie Funktion des Gebers nicht mehr gewährleistet ist. Die dazu erforderliche Meßeinrichtung kann entweder eine Meßeinrichtung sein, mit der der Innenwiderstand der Betriebsspannungsquelle, der Batterie oder des Akkumulators, überprüft wird, oder aber nur eine einfache Meßschaltung, mit der die Batteriespannung überprüft wird. Wenn beispielsweise die Batteriespannung einen Nennwert von 9 V aufweisen soll und unter 6 V absinkt, so reicht der Strom für eine genügende Strahlungsleistung der Infrarot-Sendedioden oder des Ultraschallgebers oder des Sendegenerators nicht mehr aus, um damit auch über eine bestimmte Mindestentfernung eine sichere Steuerung des zu steuernden Gerätes sicherzustellen. Beispielsweise wird ein Fernsehempfangsgerät aus einer mittleren Entfernung von 3 bis 4 m von einem Fernbedienungsgeber aus bedient. Die Bedienungsentfernung von anderen unterhaltungselektronischen Geräten, wie Videorecorder und Hifi-Anlagen und Rundfunkempfängern, weicht hiervon ebenfalls nicht ab. Gewünscht sind aber sichere Bedienungen auch aus größeren Entfernungen bis zu 10 m, insbesondere dann, wenn auch für andere Zwecke ein Fernbedienungsgeber nach der Erfindung eingesetzt wird, z.B. in Verbindung mit Garagentoröffnern mit einem fernsteuerbaren Garagentorantrieb. Die kritische Grenze der Batteriespannung muß selbstverständlich in der Überwachungseinrichtung definiert sein, um z.B. unter Verwendung eines Komparators ein Signal generieren zu können, wenn der vorgesehene Nominalwert unterschritten ist.

Vorteilhafte Weiterbildungen der Erfindung sind in den Unteransprüchen im einzelnen angegeben.

Während in den Ansprüchen 1 und 2 generell nur die Aussage enthalten ist, daß ein Informationssignal generiert wird, das beispielsweise aus einem einzigen Impuls bestehen kann oder aus einer Frequenz, die auf der Empfängerseite ausgewertet wird, ist nach Anspruch 3 vorgesehen, daß bei codierten Wortbefehlen aus einzelnen Impulsen von der Überwachungseinrichtung ein Befehlswort als Indikation für den Ladezustand generiert wird, das das gleiche Codierungsschema wie die übrigen Befehlsworte aufweist. Dadurch ist es möglich, unter Ausnutzung der gleichen Demodulatoren und Decoderschaltungen auf der Empfängerseite den Wortbefehl mit den gleichen Mitteln weiterzuverarbeiten, um darüber die Anzeigeschaltung zu steuern. Dabei kann es sich um eine Sichtanzeige oder eine akustische Anzeige handeln. Es ist aber auch möglich, daß die Auswertung des generierten Ladezustandsbefehls erst in der Empfängerschaltung selbst erfolgt und der Geber nur den Ist-Ladezustand der Batterie überträgt. Empfängerseitig erfolgt dann eine Auswertung der den Ladezustand verkörpernden Größe, derart, daß entweder angezeigt wird, daß die Batterie noch "gut" ist oder daß sie dringend gewechselt werden muß oder daß die Batterie zur Neige geht und ausgetauscht werden sollte. Ebenso können direkte optische Anzeigen über Reichweiten vorgesehen sein. Dies alles setzt voraus, daß in der Empfängerschaltung eine Auswerteschaltung implementiert ist, die aus den empfangenen Signalen unter Einbeziehung des Vergleichs mit Sollgrößen entsprechende Informationen ableitet, die dann mit dem Anzeigeelement zur Anzeige gebracht werden. Es ist aber auch nach der Erfindung möglich, den bereits ausgewerteten Anzeigebefehl, der einer bestimmten Anzeige zugeordnet ist, direkt von dem Fernbedienungsgeber nach dem gleichen Codierungsschema zu übertragen und damit die Anzeigeeinrichtung unmittelbar zu steuern.

Bei der Verwendung in einem Fernsehgerät empfiehlt es sich, anstelle eines separaten Anzeigeelementes, das selbstverständlich auch nur aus einer einzigen Leuchtdiode bestehen kann, ähnlich wie sie für die Stereoanzeige oder als Betriebsanzeige des Gerätes verwendet wird, eine Displayeinblendung auf dem Bildschirm vorzusehen. Zu diesem Zweck muß dann die Empfängerschaltung mit einem Charaktergenerator gekoppelt sein, der nach einem eingeschriebenen Programm oder nach einem eingeschriebenen Programm in einem Mikroprozessor eine Treiberstufe der Bildröhre so steuert, daß der Ladezustand durch Symbole oder durch schriftbildliche Hinweise angezeigt wird. Diese Anzeige kann dabei durch Blinken unterstützt werden. Es ist aber auch möglich, durch Generierung eines Blinksignales den Ladezustand als solchen anzuzeigen, dann bedarf es allerdings in der Bedienungsanleitung einer Erläuterung.

In modernen Fernbedienungsgebern, in denen Mikroprozessoren zur Befehlscodierung eingesetzt werden, ist eine Ladezustandsanzeige nach der Erfindung gemäß Anspruch 6 auf einfache Weise zu realisieren, wobei die Datenverarbeitung in digitaler Form erfolgt und das Informationssignal als codierter Wortbefehl an den Empfänger übertragen wird. Dieser Wortbefehl kann als zusätzliches Datenpaket entweder isoliert oder in Verbindung mit anderen Daten übertragen und nach der Decodierung von der Auswerteschaltung in dem Empfänger ausgewertet werden. Es bietet sich hierbei insbesondere an, das zusätzliche Datenpaket dem AUS-Kommando vorauszuschicken, um vor dem Abschalten des Gerätes noch einmal zu signalisieren z.B. "der Batterieladezustand des Fernbedienungsgebers gewährleistet keinen sicheren Betrieb". Der Mehraufwand im Fernbedienungsgeber besteht lediglich darin, entweder einen Spannungskomparator oder den ohnehin vorhandenen integrierten A/D-Wandler zur Spannungsauswertung der Betriebsspannung mit zu verwenden, wobei, wie bereits angegeben, es nicht erforderlich ist, bei jeder Betätigung einer Taste des Fernbedienungsgebers oder bei Eingabe eines jeden Sprachbefehls in ein Mikrofon eines Fernbedienungsgebers diese Sprachbefehle in codierte Steuerbefehle umzusetzen, abzufragen und dann das Informationssignal separat oder gekoppelt mit einem Befehl zu übertragen. Es ist auch möglich, die abgefragten Spannungswerte bzw. den Ladezustand der Batterie oder des Akkumulators abzuspeichern und mit einem bestimmten Befehl, z.B. den EIN-Befehl des Fernbedienungsgebers, mit zu übertragen und zur Anzeige zu bringen. Als Anzeigeelemente können herkömmliche 7-Segment-Anzeigen, einzelne Leuchtdioden, Leuchtdiodenketten oder aber auch die vorhandenen Displayfelder eines Gerätes ausgenutzt werden. Ebenso kann, wie bereits beschrieben, eine Einblendschaltung in einem Fernsehgerät vorgesehen sein, um die entsprechende Information auf dem Bildschirm darzustellen. Bezüglich weiterer Einzelheiten wird auf die einzelnen Ausgestaltungsformen in den Unteransprüchen verwiesen.

## Patentansprüche

1. Ladezustandsanzeige einer Batterie oder eines Akkumulators in einem Fernbedienungsgeber für nachrichtentechnische Geräte, insbesondere Geräte der Unterhaltungselektronik, z.B. Rundfunk-, Fernsehgeräte oder Videorecorder, welcher Fernbedienungsgeber mittels Tasten, Analogwertstellern oder Sprache eingegebene Befehle in einer Befehlsaufbereitungsschaltung aufbereitet und in einer Sendeschaltung mit einem Träger moduliert oder unmoduliert an das zu steuernde Gerät mit einem Übertragungsmedium, wie Infrarotlicht, Ultraschall oder elektromagnetische Wellen überträgt, mit einer Überwachungseinrichtung für die Überwachung des Ladezustandes und/oder der entsprechenden Spannung der Batterie oder des Akkumulators, welches Gerät eine Empfängerschaltung aufweist und die Befehle demoduliert, aufbereitet oder direkt zur Funktionssteuerung an die zu steuernden Funktionselemente in dem Gerät leitet, **dadurch gekennzeichnet**, daß die Überwachungseinrichtung in Abhängigkeit von dem Ladezustand der Batterie oder des Akkumulators ein adäquates Informationssignal generiert, das von dem Fernbedienungsgeber an das zu steuernde Gerät übertragen wird, das einen Fernbedienungsempfänger und eine Auswerteschaltung für das Informationssignal und ein Anzeigeelement mit einer Ansteuerschaltung zur Anzeige des Ladezustandes enthält.

2. Ladezustandsanzeige nach Anspruch 1, dadurch gekennzeichnet, daß die Überwachungseinrichtung bei Unterschreiten eines vorgegebenen Vergleichswertes bei der Ladezustandsmessung ein Informationssignal generiert.

3. Ladezustandsanzeige nach Anspruch 1 oder 2, dadurch gekennzeichnet, daß das generierte Informationssignal ein Kennsignal in Form eines Wortbefehls ist, das ein Codierungsschema aufweist, das den übrigen Fernbedienungsbefehlen entspricht, und daß eine der Empfängerschaltung mit dem Demodulator in dem zu steuernden Gerät nachgeschaltete Decoderschaltung die Wortbefehle decodiert oder die rückgewonnenen Signale direkt an eine Ansteuerschaltung zur Erzeugung eines Anzeigesignals legt, welche Ansteuerschaltung ein gesondertes oder vorhandenes Display in dem zu steuernder Gerät oder bei Verwendung in einem Fernsehempfänger einer Einblendgenerator steuert, dessen Ausgangssignale den Ladezustand oder einen hiervon abhängigen Bedienungshinweis auf dem Bildschirm darstellen.

4. Ladezustandsanzeige nach Anspruch 3, dadurch gekennzeichnet, daß eine alphanumerische Anzeige vorgesehen ist, über die der Ladezustand der Batterie angezeigt oder zum Austausch der Batterie oder des Akkumulators aufgefordert wird.

5. Ladezustandsanzeige nach einem der vorhergehenden Ansprüche, dadurch gekennzeichnet, daß in dem Fernbedienungsgeber ein Spannungskomparator vorgesehen ist, der die Batteriespannung mit einer Vergleichsspannung vergleicht.

6. Ladezustandsanzeige nach Anspruch 1, dadurch gekennzeichnet, daß der Fernbedienungsgeber einen Mikroprozessor enthält, und daß eine Meßschaltung vorgesehen ist, die die Batteriespannung oder den Innenwiderstand der Batterie mißt, und daß die Meßwerte dem Mikroprozessor direkt oder nach A/D-Wandlung zugeführt werden, und daß der Mikroprozessor nach einem eingeschriebenen Programm die Meßwerte mit Sollvorgaben vergleicht und davon abhängig eine codierte Information an den Empfänger überträgt oder die gemessenen Daten unmittelbar in einen vom Empfänger auswertbaren Datensatz umsetzt, wobei in dem Empfänger die Auswerteschaltung enthalten ist, die anhand der Ladezustandsinformation die Anzeigeschaltung aktiviert.

7. Ladezustandsanzeige nach Anspruch 1, 5 oder 6, dadurch gekennzeichnet, daß die Ladezustandsmessung bei der Betätigung einer jeden Taste oder beim Einschalten des Fernbedienungsempfängers erfolgt, und daß das Datenpaket zur Ladezustandsanzeige als Zusatzdatenpaket zu den einzelnen Funktionsbefehlsworten bei der Eingabe von Bedienungsfunktionen angehängt oder vorangestellt ist.

8. Ladezustandsanzeige nach Anspruch 1, 3 oder 7, dadurch gekennzeichnet, daß die Auswerteschaltung in dem Empfänger in Abhängigkeit von dem Ladezustand signalisiert, ob die Wahrscheinlichkeit besteht, daß der nachfolgende Funktionsbefehlssatz infolge der minderen Spannung bzw. des Ladezustandes der Batterie unvollständig oder verfälscht sein kann.

9. Ladezustandsanzeige nach Anspruch 1, 2, 5 oder 6, dadurch gekennzeichnet, daß die Messung des Ladezustandes der Batterie beim Einschalten des Gerätes über die Fernbedienung oder beim Umschalten von einem Programmplatz auf den anderen erfolgt, und daß die Ladezustandsanzeige nur aktiviert wird, wenn der Ladezustand eine einwandfreie Signalabgabe des Fernbedienungsgebers nicht mehr gewährleistet.

10. Ladezustandsanzeige nach einem der Ansprüche 1, 3, 4 oder 6 in Verbindung mit einem Fernsehempfangsgerät, dadurch gekennzeichnet, daß auf dem Bildschirm ein warnender Hinweis auf den Ladezustand durch Blinken unterstützend angezeigt ist.

11. Ladezustandsanzeige nach Anspruch 1, 4 oder 6, dadurch gekennzeichnet, daß in dem unterhaltungselektronischen Gerät ein Display mit einer alphanumerischen Betriebsanzeige vorgesehen ist, und daß hierauf der Batterieladezustand visuell beschreibend oder durch Symbole ausgedrückt dargestellt ist, oder daß nur ein Anzeigeelement an dem Gerät, wie Leuchtdiode, vorgesehen ist, das signalisiert, ob der Ladezustand der Batterie des Fernbedienungsgebers noch ausreichend ist, daß die Generierung und Übertragung der Funktionsbefehle sichergestellt sind.

12. Ladezustandsanzeige nach Anspruch 1 oder 2, dadurch gekennzeichnet, daß das zu steuernde Gerät ein akustisches Anzeigeelement enthält.

Europäisches
Patentamt

**EUROPÄISCHER RECHERCHENBERICHT**

Nummer der Anmeldung

| | **EINSCHLÄGIGE DOKUMENTE** | | EP 92101584.8 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
| P,A | DE - C - 4 038 038 (MERCEDES-BENZ) * Zusammenfassung * -- | 1 | H 01 M 10/48 G 01 R 31/36 |
| D,A | DE - A - 2 638 958 (BOSCH) * Zusammenfassung * -- | 1 | |
| D,A | DE - A - 2 847 052 (SABA) * Anspruch 1 * ---- | 1 | |

RECHERCHIERTE
SACHGEBIETE (Int. Cl.⁵)

H 01 M
H 03 J
G 01 R

Der vorliegende Recherchenbericht wurde für alle Patentansprüche erstellt.

| Recherchenort | Abschlußdatum der Recherche | Prüfer |
|---|---|---|
| WIEN | 06-05-1992 | LUX |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82